# NOUVEAU FASCICULE DE BREVET EUROPEEN

(11) **EP 0 262 036 B2**
(45) Date de publication et mention de la décision concernant l'opposition: **12.04.1995**
(45) Mention de la délivrance du brevet: 29.05.1991
(21) Numéro de dépôt: 87402090.2
(22) Date de dépôt: 18.09.1987
(51) Int. Cl.: G06K 19/07, G06K 7/06

(54) **Système de traitement d'informations à cartes à mémoire ayant plusieurs modules électroniques**
Datenverarbeitungssystem mit mit mehreren elektronischen Modulen versehenen Speicherkarten
Data processing system with memory cards having a plurality of electronic modules

(30) Priorité: 22.09.1986 FR 8613209
(43) Date de publication de la demande: 30.03.1988
(73) Titulaire: SCHLUMBERGER INDUSTRIES, F-92120 Montrouge (FR)
(72) Inventeur: Kayanakis, Georges, F-92410 Ville d'Avray (FR)
(74) Mandataire: Dronne, Guy

(56) Documents cités:
- EP-A- 0 134 109
- EP-A- 0 134 110
- EP-A- 0 138 219
- FR-A- 2 359 464
- FR-A- 2 505 523
- FR-A- 2 522 851
- US-A- 4 539 472
- PATENT ABSTRACTS OF JAPAN, vol. 7, no. 247 (E-208)[1392], 2 novembre 1983 & JP-A-58-134 456
- Résumé de JP-A-61 80482 (Hitachi Ltd) 24/04/1986

## Description

La présente invention a pour objet un système de traitement d'informations à cartes à mémoire ayant plusieurs modules électroniques.

Il existe de plus en plus de prestations auxquelles un usager peut accéder à l'aide de cartes à mémoire électronique, ou de systèmes de contrôle d'accès utilisant de telles cartes.

Avant de décrire plus en détail ces systèmes, il est important de rappeler en quoi consistent les cartes à mémoire électronique connues. La carte comporte un corps en matière plastique dans lequel est implanté un module électronique formé d'une pastille semi-conductrice dans laquelle est réalisé un circuit intégré, et de plages de contact disposées sur une face principale du corps de carte et reliées électriquement aux bornes du circuit intégré. La carte doit avoir des dimensions normalisées, notamment son épaisseur inférieure a un millimètre et la position des plages de contact par rapport aux bords de la carte. En outre, la carte avec son module électronique doit satisfaire à des tests mécaniques et notamment des tests de flexion pour s'assurer que le module électronique ne se "décollera pas" du corps de carte. Compte tenu de l'épaisseur réduite du corps de la carte l'implantation du module électronique dans le corps de la carte soulève de nombreux problèmes. En particulier les évidements nécessaires au logement du module électronique doivent être réalisés avec précision, notamment en ce qui concerne le repérage de l'emplacement de l'évidement par rapport aux cotes externes du corps de carte. De plus, l'implantation du module électronique dans le corps de carte nécessite un certain nombre d'opérations qui doivent être repétées pour la fabrication de chaque carte.

On comprend que le coût de réalisation d'un corps de carte et de fixation d'un module électronique dans le corps de carte n'est nullement négligeable. Au contraire, pour une architecture donnée, le coût de fabrication d'un circuit intégré tend à diminuer de manière significative. En conséquence, dans le coût global de fabrication d'une carte à mémoire électronique, la part imputable à la fabrication du corps de carte et à l'implantation du module électronique tend à augmenter considérablement. Il en résulte que la solution consistant, pour un même organisme, à prévoir une carte pour chaque fonction augmente considérablement le coût fixe lié à la fabrication elle-même des cartes. Ce coût fixe est d'autant plus difficilement acceptable par l'usager que la valeur fiduciaire mémorisée dans la carte est plus faible.

Pour l'usager, il est également désagréable de devoir détenir sur soi un certain nombre de cartes distinctes pour obtenir des prestations d'un usage courant.

L'autre solution, que consiste à réaliser une carte unique pour accéder à différentes prestations, impose de prévoir un circuit intégré présentant une architecture beaucoup plus compliquée pour permettre la gestion à l'aide d'un même circuit des différentes fonctions. Cela implique que le circuit intégré comporte une structure de microprocesseur ou de logique cablée et des capacités de mémoire importantes. Il en résulte d'une part que le circuit intégré aura un prix très sensiblement plus élevé et d'autre part que la surface de la pastille semi-conductrice sera bien plus importante. Le premier point a pour conséquence de limiter le nombre de fonctions à une valeur très réduite. Le deuxième point rend bien sûr beaucoup plus délicate l'implantation du module électronique dans la carte.

En outre, si le nombre de prestations accessibles augmente ou si l'accès à des réseaux de gestion d'informations doit être mieux protégé, il est nécessaire que les procédures d'authorisation ou d'authentification de la carte et/ou du porteur de celle-ci soient renforcées sans que cela constitue une gêne pour l'usager, c'est-à-dire sans que cela rende plus complexe les opérations qu'il doit effectuer pour avoir accès aux prestations ou au réseau d'informations.

Un objet de l'invention est de fournir un système de gestion d'informations à cartes à mémoire à plusieurs modules électroniques qui ne présente pas les inconvénients mentionnés précédemment.

Avant de décrire l'invention, il est utile de préciser ce qu'il faut entendre, dans la suite du présent texte, par "dispositif de traitement de cartes".

Par "dispositif de traitement de cartes" il faut entendre des dispositifs dans lesquels une carte à mémoire électronique peut être introduite et qui est capable de lire les informations mémorisées dans la carte, d'écrire d'autres informations dans la carte, et enfin de traiter les informations lues et des informations venant de l'extérieur pour autoriser l'accès à une prestation ou à un réseau d'informations. Comme cela est bien connue, une autre fonction du dispositif de traitement est de fournir au circuit intégré de la carte son alimentation électrique puisque la carte elle-même ne comporte , en général, pas de source d'énergie. De tels dispositifs sont décrits dans la demande de brevet européen 139.593 publiée le 02 mai 1985 et dans la demande de brevet européen 0 134 109 publiée le 13 mars 1985.

Patent Abstracts of Japan, Vol 7, N° 247 (E-208)[1392] du 2 novembre 1983 décrit une carte à mèmoire ayant deux modules électroniques. Dans ce document la fiabilité de la carte est améliorée en stockant des informations en double dans les modules respectifs ou bien la carte peut être du type "usage multiple" dans laquelle chaque module contient des informations de types différents.

Pour atteindre ce but, selon l'invention, le système de traitement d'informations à cartes à mémoire qui comportent plusieurs modules électroniques comprend: une pluralité de cartes à mémoire et au moins un dispositif de traitement desdites cartes, chaque carte comprenant un corps présentant une première face principale et une deuxième face principale sensiblement parallèle à la première face, et au moins deux modules électroniques chaque module électronique comportant une pastille semi-conductrice formant un circuit intégré, une pluralité de plages de contact externe et des moyens pour relier électriquement lesdites plages aux bornes de ladite pastille, le circuit intégré d'au moins un desdits modules incluant une mémoire non-volatile, et le circuit intégré d'un desdits modules comprenant des moyens de traitement de l'information comportant des moyens pour coder une information appliquée à son entrée, chaque module électronique étant logé dans une cavité ménagée dans ledit corps de la carte pour que lesdites plages de contact soient disposées sensiblement dans le plan d'une des faces principales du corps de la carte, le circuit intégré de l'autre module comportant des moyens pour mémoriser de façon non volatile lesdites informations codées, ledit dispositif de traitement comprenant des moyens pour guider ladite carte jusqu'à une position de traitement, un ensemble de traitement d'informations et d'alimentation électrique desdit circuits intégrés de la carte, et au moins deux têtes de lecture/écriture pour réaliser une liaison électrique simultanée entre lesdits ensembles de plages de contact électrique desdits modules électroniques et ledit ensemble de traitement et d'alimentation lorsque ladite carte est en position de traitement, par quoi durant chaque opération de traitement des informations sont échangées entre les deux modules et l'ensemble de traitement d'informations du dispositif de traitement.

On comprend qu'ainsi la gestion complète de la carte fait intervenir non seulement des données ou instructions stockées dans le dispositif de traitement de la carte, mais également des données et/ou instructions contenues dans les deux circuits intégrés. Il est donc bien plus difficile de frauder avec un tel système qu'avec les systèmes connus à un seul circuit intégré ou à deux circuits intégrés interconnectés dans la carte elle-même.

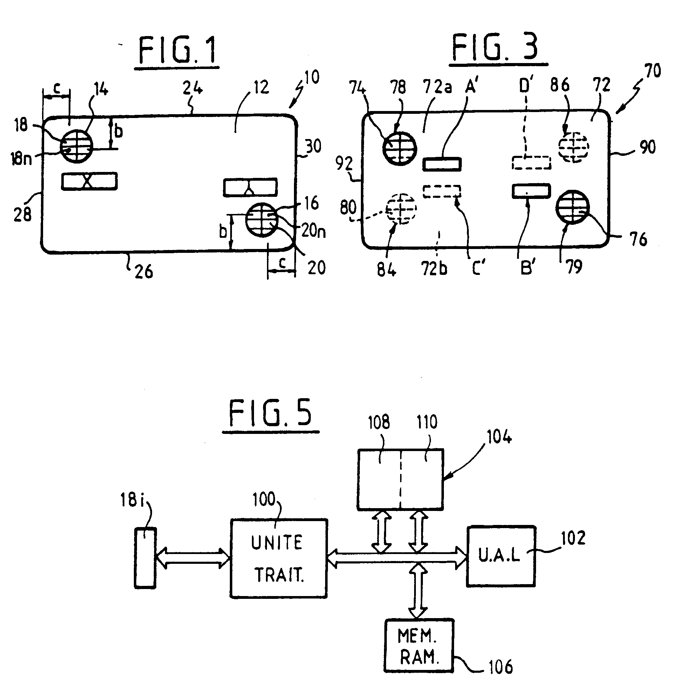

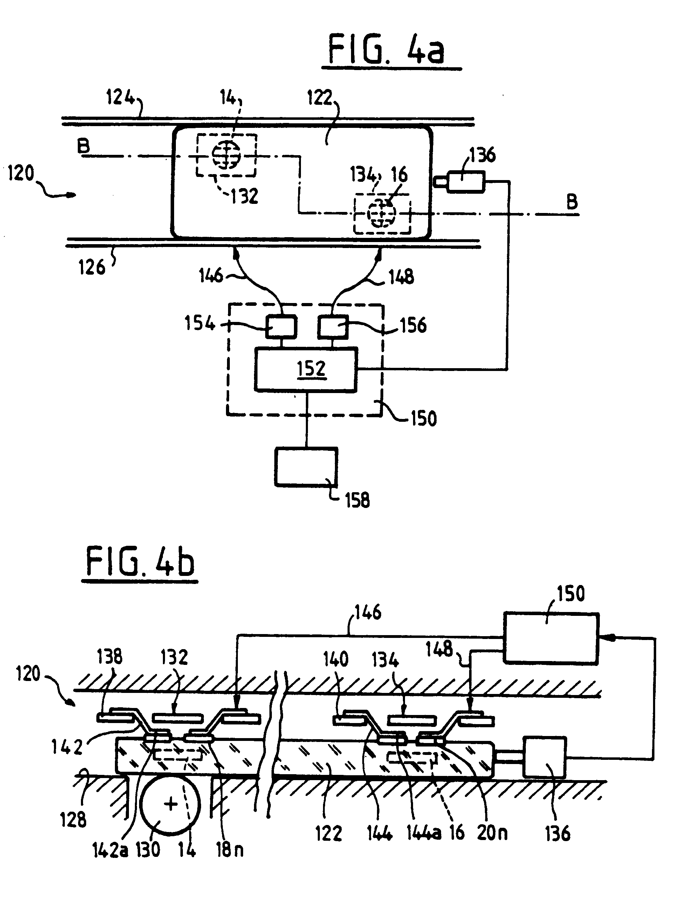

D'autres caractéristiques et avantages de l'invention apparaîtront plus clairement à la lecture de la description qui suit de plusieurs modes de réalisation de l'invention donnés à titre d'exemples non limitatifs. La description se réfère au dessin annexé sur lequel :
. La figure 1 est une vue de dessus d'une carte à mémoire électronique comprenant deux modules électroniques distincts ;
. La figure 3 est une vue de dessus d'une carte à mémoire électronique comprenant quatre modules électroniques distincts ;
. Les figures 4a et 4b sont des vues respectivement de dessus (4a) et en coupe verticale (4b) selon la ligne B-B de la figure 4a, d'un mode de réalisation d'un lecteur de cartes selon l'invention : et
. la figure 5 montre la structure d'un circuit intégré réalisé dans un des modules électroniques pour permettre le codage des informations.

La figure 1 montre un premier mode de réalisation d'une carte à mémoire électronique. La carte 10 comprend un corps 12 de forme générale parallèlipipédique rectangle. Le corps 12 est réalisé par exemple en un matériau plastique tel que du PVC. L'épaisseur du corps est normalisée et inférieure à 1 mm.

La carte comporte également deux modules électroniques 14 et 16 dont on ne voit que les ensembles de plages de contact électrique 18 et 20.

Le module électronique 14,16 peut être réalisé de différentes manières avant son implantation dans le corps de carte. Il comprend toujours une pastille semi-conductrice dans laquelle est réalisé un circuit intégré dont une partie constitue la mémoire, ainsi que des liaisons électriques reliant les bornes de la pastille semi-conductrice aux plages de contact électrique 18, 20. Les modules électroniques 14 et 16 sont implantés dans le corps de la carte de telle manière que les plages de contact électrique soient sensiblement au même niveau que la face principale supérieure 12a du corps de carte.

La demande de brevet européen N ° 128.822 publiée le 19 décembre 1984 au nom de Flonic montre différents modes de réalisation d'un module électronique et différents modes d'implantation du module électronique dans le corps de la carte. Il va cependant de soi qu'on ne sortirait pas de l'invention en utilisant d'autres formes de module électronique ou d'autres procédés d'implantation.

De préférence, les ensembles de plages de contact électrique sont disposés de telle manière qu'une plage de contact 18ₙ du module électronique 14 et la plage 20ₙ correspondante du module 16 soient toutes les deux à la même distance b respectivement du grand bord 24 et du grand bord 26 et à la même distance c respectivemùent du petit bord 28 et du petit bord 30.

La figure 3 montre un deuxième mode de réalisation d'une carte à mémoire électronique selon l'invention. La carte 70 comprend un corps 72 ayant exactement les mêmes caractéristiques que le corps 12 de la carte 10. La première face principale 72 a de la carte (visible sur la figure 3) comporte deux ensembles de plages de contact électrique 74 et 76 faisant partie de deux modules électroniques 78 et 79. Les ensembles de plages de contact 74 et 76 sont disposés dans la face 72 a de la carte 70 exactement comme les ensembles de plages de contact 18 et 20 le sont dans la face 12 a de la carte de la figure 1. La deuxième face 72 b de la carte comporte également deux ensembles de plages de contact 80 et 82 faisant respectivement partie de deux autres modules électroniques 84 et 86.

De préférence, si l'on regarde la face 72 b de la carte les ensembles de plages de contact 80 et 82 occupent exactement la même position que les ensembles 74 et 76 dans la face 72 a.

En se référant aux figures 4 on va décrire un lecteur de cartes selon l'invention pour fonctionner avec une carte du type représenté sur la figure 1. Dans cet exemple, le circuit intégré du module électronique 14 sert au codage et au décodage d'informations et le module électronique 16 sert uniquement à la mémorisation des informations codées.

Comme le montre la figure 5, le circuit intégré du module 14 comprend essentiellement une unité de traitement 100, une unité arithmétique et logique 102, une première mémoire de programme et de données fixes 104, par exemple du type PROM, et une deuxième mémoire de travail 106, par exemple du type RAM. La première mémoire comporte une première zone protégée 108 qui est inaccessible de l'extérieur en écriture ou en lecture et une deuxième zone 110 accessible de l'extérieur en écriture et en lecture. Les plages de contact 18 sont directement reliées à l'unité de traitement 100 de telle manière que l'uni té de traitement 100 contrôle intégralement le fonctionnement du circuit intégré. La zone de mémoire protégées 108 contient en particulier les paramètres de codage et de décodage des informations à coder. La mémoire de programme 104 contient également les instructions nécessaires au déroulement des algorithmes de codage et de décodage qui font intervenir l'unité arithmétique et logique 102. Ces systèmes de codage sont bien connus. Il s'agit par exmple du code RSA ou du code DES.

Le deuxième module électronique 16 est uniquement constitué par une mémoire non-volatile programmable et par son circuit d'écriture-lecture. La pastille semi-conductrice ne comportant que la mémoire, celle-ci peut avoir une capacité importante.

Les figures 4a et 4b montrent un dispositif de traitement de cartes à mémoire électronique utilisable avec une carte décrite précédemment en liaison avec la figure 5. Le dispositif comprend un passage 120 d'introduction de carte 122 limité latéralement par des parois de guidage 124 et 126 et inférieurement par un plancher 128. Sur la figure 4b on a représenté de façon simplifiée un galet 130 pour entraîner la carte 122 en position de lecture, et pour l'éjection de la carte hors du passage, après le traitement de celle-ci.

Le dispositif de lecture-écriture comprend également deux têtes de lecture-écriture 132 et 134 qui sont respectivement disposées dans le passage d'introduction 120 pour entrer en contact avec les ensembles de plages de contact 18 et 20 des modules électroniques 14 et 16 de la carte 122, lorsque celle-ci est en position de traitement. L'arrivée de la carte 122 en position de traitement est détectée par le micro-contact électrique 136. Chaque tête 132, 134 comprend un support isolant 138, 140 sur lequel sont fixées des lames de contact 142, 144. Les extrémités 142 a et 144 a des lames de contact 142 et 144 reproduisent respectivement la configuration spatiale des plages de contact 18n et 20n. Les lames de contact 142 et 144 sont reliées par des conducteurs tels que 146 et 148 à un ensemble de traitement 150 du dispositif de lecture-écriture.

L'ensemble de traitement reçoit également le signal délivré par le micro-contact 136 lorsque la carte 122 est en position de traitement.

L'ensemble de traitement 150 comprend une unité de traitement 152, un circuit d'écriture-lecture 154 associé à la tête de lecture-écriture 132 et un circuit d'écriture-lecture 134. L'ensemble de traitement 150 permet également l'alimentation électrique des circuits intégrés des modules électroniques 14 et 16. Le dispositif de traitement de la carte comporte enfin un moyen d'entrée d'informations 158 constitué, par exemple par un clavier numérique ou alphanumérique. Les informations susceptibles d'être introduites sont, par exemple, le numéro d'identification personnel du détenieur de la carte et le montant de la transaction que le détenteur de la carte veut effectuer.

Comme on vient de l'expliquer, lorsque la carte est en position de traitement dans le passage d'introduction 120, ce qui est détecté par le micro-contact 136, les plages de contact des deux modules électroniques sont en liaison électrique avec les lames conductrices 142 et 144 des deux têtes de lecture-écriture 132 et 134. En conséquence, les deux circuits intégrés des modules électroniques sont alimentés en énergie électrique, et l'unité de traitement 152 peut travailler simultanément avec les deux circuits intégrés.

Le dialogue entre le dispositif de traitement des cartes à mémoire et les deux circuits intégrés de la carte se déroule différemment selon la nature de l'opération à effectuer. On peut cependant énoncer des règles générales dans le cas de l'application décrite en liaison avec la figure 4.

La totalité des informations mémorisées dans la mémoire du module 16 sont écrites dans cette mémoire sous forme codée. L'information en clair, introduite par exemple à l'aide du clavier 158 o u directement élaborée par l'unité de traitement 150, est d'abord envoyée via la tête d'écriture 132 dans le circuit intégré du module 14. Ce circuit met en oeuvre l'algorithme de codage contenu dans la mémoire 104 de ce circuit. L'information codée est renvoyée à l'ensemble de traitement 150 du dispositif de traitement puis écrite dans la mémoire du circuit du module 16, par l'intermédiaire de la tête de lecture-écriture 134.

L'information codée peut également être d'abord traitée par le circuit 14. C'est le cas lorsque l'information entrée est le numéro personnel d'identification du porteur de la carte. Le numéro d'identification déjà codé est lui dans la mémoire du circuit 16 et écrit temporairement dans la mémoire du circuit 14. Le numéro d'identification codé est décodé dans ce circuit à l'aide de l'algorithme inverse et comparé au numéro d'identification introduit en clair par le porteur de la carte à l'aide du clavier 158. Les deux numéros d'identification sont comparés. S'ils sont identiques le circuit 14 délivre vers l'ensemble de traitement 150 un signal d'autorisation pour effectuer la suite des opérations nécessaires à la fourniture de la prestation souhaitée.

On comprend que le circuit du module 16 qui contient la mémoire non volatile n'a pas besoin de circuits de protection d'accès en lecture et en écriture. En effet, toutes les informations qui y sont stockées le sont sous forme codée. La lecture de ces informations est donc sans intérêt pour un fraudeur. De même, la modification frauduleuse des informations qui y sont écrites ne peut avoir pour effet que de rendre la carte inutilisable. En effet, le décodage des informations modifiées aboutirait à une information en clair inconnue et donc inutilisable pour l'obtention d'une prestation. La totalité de la surface de semi-conducteur du module électronique 16 peut donc être utilisée pour réaliser la mémoire non volatile.

Le système décrit précédemment peut également être utilisé pour contrôler l'accès à un réseau d'informations. Le circuit 14 contient encore un algorithme de codage et des données d'identification. La mémoire du circuit 16 sert à enregistrer, par exemple, les instants où l'accès a été autorisé.

Il va de soi que, selon ce mode d'utilisation de la carte les deux modules électroniques utilisés simultanément pourraient être disposés aux deux coins d'une même face du corps de la carte, le long d'un même grand bord de celle-ci. Dans ce cas, les deux têtes de lecture-écriture du dispositif de traitement de cartes seraient alignées selon la direction d'introduction des cartes.

Selon un autre mode de réalisation du système de gestion le premier module électronique 14 de la carte ne comporte qu'une unité de traitement qui traite des données ou informations reçues du dispositif de lecture/écriture et qui restitue au dispositif de lecture/écriture des données ou informations modifiées.

Le module 14 peut également comprendre en plus de l'unité de traitement une mémoire RAM de travail pour mémoriser temporairement des étapes intermédiaires de traitement.

Le module 14 peut encore comporter, outre l'unité de traitement, une mémoire RAM de travail et une mémoire ROM dans laquelle est mémorisé le programme mis en oeuvre par l'unité de traitement.

Enfin il est possible que le deuxième module électronique 16 ait la même structure que le module électronique 14, c'est-à-dire qu'il comporte également une unité de traitement. Dans ce cas, le traitement global réalisé par le système de traitement d'information fait intervenir effectivement le dispositif de lecture/écriture et les unités de traitement des deux modules électronique.

On peut également utiliser des cartes du type représenté sur la figure 3. De telles cartes pourront permettre la mise en oeuvre de deux fonctions distinctes selon la manière dont la carte est introduite dans le lecteur, plus précisément selon la face du corps de carte qui est tournée vers I a tête de lecture.

## Revendications

1. Système de traitement d'informations à cartes à mémoire qui comportent plusieurs modules électroniques, le système comprenant une pluralité de cartes à mémoire et au moins un dispositif de traitement desdites cartes, chaque carte (10, 70, 122) comprenant un corps (12, 72) présentant une première face principale (12, 72a) et une deuxième face principale sensiblement parallèle à la première face, et au moins deux modules électroniques (14, 16, 78, 79), chaque module électronique comportant une pastille semi-conductrice formant un circuit intégré, une pluralité de plages de contact (18, 20, 74, 76) externe et des moyens pour relier électriquement lesdites plages aux bornes de ladite pastille, le circuit intégré d'au moins un desdits modules incluant une mémoire non-volatile, et le circuit intégré d'un desdits modules (14) comprenant des moyens de traitement de l'information (100, 102, 104, 106) comportant des moyens pour coder une information appliquée à son entrée, chaque module électronique étant logé dans une cavité ménagée dans ledit corps de la carte pour que lesdites plages de contact soient disposées sensiblement dans le plan d'une des faces principales du corps de la carte, le circuit intégré de l'autre module (16) comportant des moyens pour mémoriser de façon non volatile lesdites informations codées, ledit dispositif de traitement comprenant des moyens (120, 124, 126, 128, 130) pour guider ladite carte jusqu'à une position de traitement, un ensemble de traitement d'informations et d'alimentation électrique (150) desdits circuits intégrés de la carte, et au moins deux têtes de lecture/écriture (132, 134) pour réaliser une liaison électrique simultanée entre lesdits ensembles de plages de contact électrique desdits modules électroniques et ledit ensemble de traitement et d'alimentation (150) lorsque ladite carte est en position de traitement, par quoi durant chaque opération de traitement des informations sont échangées entre les deux modules et l'ensemble de traitement d'informations du dispositif de traitement.

2. Système selon la revendication 1, caractérisé en ce que les circuits intégrés des deux modules électroniques comprennent chacun une mémoire non-volatile.

3. Système selon l'une quelconque des revendications 1 à 2, caractérisé en ce que ladite carte (70) comporte quatre modules électroniques (78, 79, 84, 86) comportant chacun une pastille semi-conductrice formant un circuit intégré, une pluralité de plages de contact (74, 76, 80, 82) externe reliées électriquement aux bornes de ladite pastille, et en ce que chaque dispositif de traitement comprend deux têtes de lecture/écriture (132, 134) pour réaliser une liaison électrique simultanée entre les plages de contact de deux des quatre modules et ledit dispositif de traitement, les deux modules électroniques reliés simultanément étant définis par le mode d'introduction de ladite carte dans lesdits moyens de guidage de la carte.

## Claims

1. Data processing system using memory cards including several electronic modules, the system comprising a plurality of memory cards and at least one device for processing the said cards ; each card (10, 70, 122) consisting of a body (12, 72) presenting a first principal surface (12a, 72a) and a second principal surface which is generally parallel with the first surface, and at least two electronic modules (14, 16, 78, 79) each of which includes a semi-conductor chip forming an integrated circuit, a plurality of external contact pads (18, 20, 74, 76) and means for electrically connecting the said pads to the terminals of the said chip, the integrated circuit of at least one of the said modules including a non-volatile memory, and the integrated circuit of at least one of the said modules (14) consisting of data processing means (100, 102, 104, 106) comprising means for coding data applied to its input, each electronic module being accommodated in a cavity arranged in the said body of the card so that the said contact pads should be disposed generally in the plane of one of the principal surfaces of the body of the card, the integrated circuit of the other module (16) consisting of the non-volatile storing in memory of the said coded data ; the said processing device consisting of means (120, 124, 126, 128, 130) for guiding the card to a processing position, a data processing and power supply assembly (150) for the said integrated circuits of the card, and at least two read/write heads (132, 134) for establishing a simultaneous electrical connection between the said units of electric contact pads of said electronic modules and the said data processing and power supply assembly (150) when the said card is in the processing position, whereby during each processing operation data are exchanged between the two modules and the data processing unit of the processing device.

2. A system according to claim 1, characterised in that each of the integrated circuit of the two electronic modules contains a non-volatile memory.

3. A system according to any of claims 1 to 2, characterised in that the said card (70) includes four electronic modules (78, 79, 84, 86) each consisting of a semi-conductor chip forming an integrated circuit, a plurality of external contact pads electrically connected to the terminals of the said chip, and in that each processing device consists of two read/write heads (132, 134) for establishing a simultaneous electrical contact between two of the four modules and the said processing device, the two simultaneously connected electronic modules being determined by the mode of introducing the said card into the said card guiding means.

## Patentansprüche

1. Datenverarbeitungssystem für Speicherkarten, die mehrere elektronische Module aufweisen, wobei das System mehrere der Speicherkarten und zumindest eine Vorrichtung zur Verarbeitung dieser Karten aufweist; wobei jede Karte (10, 70, 122) einen Körper (12, 72) aufweist mit einer ersten Hauptfläche (12a, 72a) und einer zu ihr im wesentlichen parallelen zweiten Hauptfläche, und zumindest zwei elektronische Module (14, 16, 78, 79), von denen jeder ein einen integrierten Schaltkreis bildendes Halbleiterplättchen aufweist, mehrere äußere Kontaktflächen (18, 20, 74, 76) sowie Mittel, um die Kontaktflächen elektrisch mit den Anschlüssen des Halbleiterplättchens zu verbinden, wobei die integrierte Schaltung zumindest einer der Module einen nichtfliichtigen Speicher umfaßt, und wobei der integrierte Schaltkreis zumindest einer der Module (14) Mittel (100, 102, 104, 106) zur Datenverarbeitung aufweist, die Mittel zum Kodieren der an seinem Eingang angelegten Informationen umfassen ; jedes elektronische Modul liegt an einer um Kartenkörper ausgesparten Höhlung, so daß sich die Kontaktflächen näherungsweise in der Ebene einer der Hauptflächen des Kartenkörpers befinden, wobei die integrierte Schaltung des anderen Moduls (16) Mittel zum nicht-flüchtigen Einspeichern der genannten kodierten Informationen aufweist; wobei die Verarbeitungvorrichtung Mittel (120, 124, 126, 128, 130) umfaßt zum Fiihren der Karte bis hin zu einer Verarbeitungsposition, eine Anordnung zur Informationsverarbeitung und eine Stromversorgung (150) für die inegrierten Schaltungen der Karte, und zumindest zwei Lese-Schreib-Köpfe (132, 134) um eine elektrische Verbindung gleichzeitig zwischen der Anordnung der elektrischen Kontaktflächen der elektronischen Module und der Anordnung zur Verarbeitung und Stromversorgung (150) zu bilden, wenn die Karte in der Verarbeitungsposition ist, wodurch bei jedem Verarbeitungsschritt Informationen zwischen den zwei Modulen und der Anordnung zur Informationsverarbeitung der Vorrichtung zur Verarbeitung ausgetauscht werden.

2. System nach Anspruch 1, dadurch gekennzeichnet, daß die integrierten Schaltungen der zwei elektronischen Module jeweils einen nichtflüchtigen Speicher aufweisen.

3. System nach einem der Ansprüche 1 und 2, dadurch gekennzeichnet, daß die Karte (70) vier elektronische Module (78, 79, 84, 86) aufweist, von denen jedes ein eine integrierte Schaltung bildenes Halbleiterplättchen umfaßt, mehrere äußere Kontaktflächen (74, 76, 80, 82), die mit den Anschlüssen der Halbleiterplättchen elektrisch verbunden sind, und dadurch, daß jede Verarbeitungsvorrichtung zwei Lese-Schreib-Köpfe (132,134) umfaßt, um eine gleichzeitige elektrische Verbindung zwischen den Kontaktflächen von zweien der vier Modulen und der Verarbeitungsvorrichtung zu bilden, wobei die zwei gleichzeitig elektronisch verbundenen Module durch die Weise festgelegt werden, wie die Karte in die Mittel zur Fiihrung der Karte eingelegt wird.
